# EUROPÄISCHE PATENTSCHRIFT

(11) **EP 2 196 074 B1**
(45) Veröffentlichungstag und Bekanntmachung des Hinweises auf die Patenterteilung: **09.02.2011**
(21) Anmeldenummer: 08785057.4
(22) Anmeldetag: 25.07.2008
(51) Int. Cl.: H05K 5/02, H05K 7/14

(54) **VERRIEGELUNGSEINRICHTUNG FÜR EIN GEHÄUSE ZUR AUFNAHME EINES EINSTECKMODULS**
LOCKING MECHANISM FOR A HOUSING TO HOLD A PLUG-IN MODULE
DISPOSITIF DE VERROUILLAGE POUR UN BOÎTIER DESTINÉ À LOGER UN MODULE ENFICHABLE

(30) Priorität: 31.08.2007 DE 102007041406
(43) Veröffentlichungstag der Anmeldung: 16.06.2010
(73) Patentinhaber: Phoenix Contact GmbH & Co. KG, 32825 Blomberg (DE)
(72) Erfinder: SÖFKER, Jörg, 32657 Lemgo (DE); BEST, Frank, 31675 Bückeburg (DE)
(74) Vertreter: Michalski Hüttermann & Partner Patentanwälte
(86) Internationale Anmeldenummer: PCT/EP2008/006104
(87) Internationale Veröffentlichungsnummer: WO 2009/030315

(56) Entgegenhaltungen:
- DE-C1- 3 245 522
- US-A- 4 659 159
- US-A- 5 253 140
- US-A1- 2002 142 642
- US-B1- 6 839 239

## Beschreibung

Die vorliegende Erfindung betrifft eine Verriegelungseinrichtung und ein mit einer solchen Verriegelungseinrichtung ausgerüstetes Gehäuse zur Aufnahme wenigstens eines Einsteckmoduls, wobei eine Betätigungseinrichtung zum Entriegeln des Einsteckmoduls vorgesehen ist.

Erfindungsgemäße Gehäuse nehmen bevorzugt modulare Ein-Ausgabemodule auf, also elektrische bzw. elektronische Module, die in Steuerungsanlagen oder in der Prozessautomatisierung eingesetzt werden. Die Gehäuse werden dabei typischerweise auf z.B. einer Montage- und/oder Tragschiene aufgesetzt und mit einem Bussystem oder Brückungssystem verbunden. Auf das Gehäuse werden ein oder mehrere Einsteckmodule eingesteckt, sodass bei Austausch eines Einsteckmoduls das entsprechende Modul abgezogen und ein neues oder entsprechend anderes Modul eingesteckt werden kann. Zum Abziehen eines eingesteckten Moduls sind oftmals hohe Haltekräfte zu überwinden, da die hochpoligen Steckverbinder eine erhebliche Rückhaltekraft ausüben. Deshalb ist der Austausch einzelner oder vieler Einsteckmodule zeitraubend und anstrengend.

Außerdem werden in der Regel viele solcher als z.B. Trägergehäuse ausgeführten Gehäuse, in denen ein oder zwei Einsteckmodule aufgenommen sind, dicht benachbart zueinander an einer Tragschiene oder einer sonstigen Tragschiene aufgenommen. Des Weiteren können mehrere Tragschienen nebeneinander angeordnet sein, sodass sich ein ganzes Feld von mit Einsteckmodulen ausgerüsteten Gehäusen ergibt. Um den für ein solches Feld nötigen Bauraum zu reduzieren, sitzen die einzelnen Gehäuse sehr eng beieinander, sodass der Platz zum Einsatz von Werkzeugen zum Entfernen der Einsteckmodule sehr begrenzt ist. Jedenfalls muss eine zuverlässige Funktion der Einsteckmodule gewährleistet werden. Auch aus diesem Grunde sind Gehäuse bekannt geworden, bei denen eine Verriegelung der eingesteckten Einsteckmodule erfolgt, um die Funktion sicherzustellen. Dazu sind im Stand der Technik Systeme bekannt geworden, bei denen ein Einsteckmodul an dem Gehäuse angeschraubt wird, um einen sicheren Halt zu ermöglichen. Nachteilig daran ist insbesondere der erhöhte Demontageaufwand und des weiteren, dass der Benutzer zwei Hände benötigt, um mit einer Hand das Einsteckmodul festzuhalten, während er mit der anderen Hand den Schraubendreher dreht.

Bei einem weiteren bekannten System kann ein neues Einsteckmodul auf einen leeren Einsteckplatz aufgesteckt werden, wobei durch Einrasten des Gehäuses oder des Einsteckmoduls eine Rastwirkung erzielt wird, sodass das Einsteckmodul zuverlässig aufgenommen wird und zur Montage nur ein gradliniges Aufstecken erforderlich ist. Nachteilig bei diesem bekannten Stand der Technik ist allerdings, dass beim Austausch eines Einsteckmoduls zur Entnahme einerseits eine Entriegelung von mehreren Verbindungselementen durchgeführt werden muss, während andererseits das entriegelte Einsteckmodul gegen die hohen Haltekräfte abgezogen werden muss.

Bei einer flächenmäßig dichten Anordnung einer Vielzahl von Gehäusen steht, wie zuvor beschrieben, nur wenig Platz zwischen den einzelnen Gehäusen zur Verfügung, um ein Werkzeug für eine Entriegelung oder dergleichen einzusetzen, sodass im Stand der Technik meist mehrere Verbindungselemente entriegelt werden müssen und anschließend das Einsteckmodul gegen die hohen Haltekräfte abgezogen werden muss.

Gemäß einem weiteren bekannten Stand der Technik wird das Einsteckmodul ohne Rastung in einen Steckverbinder eingesteckt und zum Lösen des Einsteckmoduls wird ein Hebel umgelegt, der über einen Nocken oder dergleichen das Einsteckmodul aus dem Steckverbinder herausdrückt. Nachteilig bei diesem Stand der Technik ist allerdings, dass keine Verriegelungsfunktion vorliegt und dass beim Herausdrücken des Einsteckmoduls eine einseitige Belastung vorliegt, sodass kein gradliniges Herausdrücken des Einsteckmoduls erfolgt. Auch bei dieser Lösung müssen mehrere Mechanismen nacheinander betätigt werden, um ein Einsteckmodul zu entfernen, sodass ein erhöhter Montageaufwand vorliegt, während gleichzeitig eine Verriegelung nicht sichergestellt werden kann.

Eine weitere bekannte Lösung besteht in der Anordnung von zwei Lösehebeln, die symmetrisch das Einsteckmodul von unten ergreifen und aus dem Steckverbinder herausdrücken. Nachteilig bei dieser technischen Lösung ist der hohe Aufwand für die unterschiedlichen Mechaniken, während gleichzeitig keine Verriegelung erfolgt. Eine solche Verriegelungseinrichtung ist auch aus dem Dokument

US-A-4 659 159 bekannt.

Vor dem angeführten Stand der Technik ist es deshalb die Aufgabe der vorliegenden Erfindung, eine Verriegelungseinrichtung für ein Gehäuse zur Aufnahme wenigstens eines Einsteckmoduls, sowie ein mit einer entsprechenden Verriegelungseinrichtung versehenes Gehäuse zur Verfügung zu stellen, bei der bzw. bei dem eine Verriegelung möglich ist, während andererseits eine einfache Montage und Entnahme eines Einsteckmoduls erfolgen kann.

Diese Aufgabe wird gelöst durch eine Verriegelungseinrichtung mit den Merkmalen des Anspruchs 1 und durch ein Gehäuse mit den Merkmalen des Anspruchs 5 und durch ein Modulsystem mit den Merkmalen des Anspruchs 11. Bevorzugte Weiterbildungen sind Gegenstand der Unteransprüche. Weitere vorteilhafte Merkmale der Erfindung ergeben sich aus der folgenden Beschreibung.

Die erfindungsgemäße Verriegelungseinrichtung für ein Gehäuse zur Aufnahme wenigstens eines Einsteckmoduls weist eine Betätigungseinrichtung zum Entriegeln des Einsteckmoduls auf. Dabei ist die Betätigungseinrichtung mit einer Anhebeeinrichtung verbunden, um mit dem Entriegeln ein in dem Gehäuse aufgenommenes Einsteckmodul anzuheben.

Die erfindungsgemäße Verriegelungseinrichtung hat viele Vorteile. Dadurch, dass die Betätigungseinrichtung mit der Anhebeeinrichtung verbunden ist, wird durch den Entriegelungsvorgang das in einem zugehörigen Gehäuse gegebenenfalls aufgenommene Einsteckmodul angehoben, sodass es leichter aus einem Gehäuse entnehmbar ist. Folglich wird erfindungsgemäß nicht nur eine Verriegelungs- und Entriegelungsfunktion zur Verfügung gestellt, sondern gleichzeitig wird beim Entriegeln das insbesondere elektrische oder elektronische Einsteckmodul angehoben, um die Entnahme zu erleichtern. Dies ist vorzugsweise auch bei angeschlossener Spannungsversorgung möglich, so dass ein schneller Wechsel solcher Einsteckmodule erfolgen kann. In einem Arbeitsgang findet vorzugsweise gleichzeitig sowohl ein Entriegeln als auch ein Auswerfen des elektronischen Einsteckmoduls statt.

Die Erfindung ermöglicht somit einen einfachen Austausch, während gleichzeitig eine einfache Lösung zur Verfügung gestellt wird, die wenig Teile benötigt und günstig herzustellen ist. Das sind erhebliche Vorteile, da bei solchen Verriegelungseinrichtungen und zugehörigen Gehäusen oft hohe Stückzahlen vorliegen, bei denen der Einzelpreis eine wichtige Rolle spielt.

Unter dem Begriff "anheben" wird im Sinne dieser Anmeldung ein Abheben des Einsteckmoduls aus dem Gehäuse verstanden, sodass sich nach dem Anhebevorgang der Abstand des im Gehäuse aufgenommenen Steckverbinders des Einsteckmoduls vergrößert hat. Der größte Kraftaufwand insbesondere zum Beginn des Entnahmevorgangs wird hiermit bereits beim Entriegeln überwunden.

In einer bevorzugten Weiterbildung der erfindungsgemäßen Verriegelungseinrichtung wird die Betätigungseinrichtung zum Entriegeln translatorisch bewegt, wobei die Betätigungseinrichtung insbesondere nur in einer translatorischen Richtung bewegbar ist. Das bietet Vorteile, da durch eine einfache translatorische bzw. gradlinige Bewegung der Betätigungseinrichtung das Einsteckmodul entriegelt und angehoben wird, um die Entnahme zu erleichtern.

Vorzugsweise weist die Anhebeeinrichtung wenigstens eine geneigte Anhebefläche auf. Dabei kann eine geneigte Anhebefläche vorgesehen sein, die dann insbesondere mittig von unten auf das Einsteckmodul einwirkt. Um eine Verkippung des Einsteckmoduls zu verhindern, kann dann insbesondere eine Außenführung des Einsteckmoduls vorgesehen sein.

Vorzugsweise werden zwei oder mehr Anhebeflächen eingesetzt, wobei aber jedenfalls schon bei Einsatz von zwei Anhebeflächen und geeigneter Platzierung der Anhebeflächen auf eine Außenführung verzichtet werden kann.

Die Anhebefläche ist insbesondere als Anhebeschräge oder als Auswurfschräge ausgeführt, sodass das Einsteckmodul durch das Bedienen der Betätigungseinrichtung ausgeworfen wird.

In vorteilhaften Weiterbildungen weist wenigstens eine Anhebefläche wenigstens zwei Bereiche mit unterschiedlichen Neigungen auf, um die Anhebegeschwindigkeit und damit insbesondere das Weg-/Kraftverhältnis steuern zu können. Zum Anheben des Einsteckmoduls wirken die Anhebeflächen mit entsprechenden Kanten an dem Einsteckmodul zusammen, wobei durch eine translatorische Bewegung der Betätigungseinrichtung die geneigten Anhebeflächen mit entsprechenden Kanten an dem Einsteckmodul in Kontakt geraten. Bei der weiteren translatorischen Bewegung wird das Einsteckmodul durch das Zusammenwirken der Anhebefläche mit der Kante des Einsteckmoduls quer zur Betätigungsrichtung der Betätigungseinrichtung angehoben.

Durch die Anordnung von zwei Bereichen mit unterschiedlichen Neigungen kann vorteilhafterweise die jeweilige Geschwindigkeit des Anhebevorgangs und damit insbesondere das Verhältnis zwischen Weg und Kraft entsprechend angepasst werden, da bei einer stärkeren Steigung die Anhebegeschwindigkeit größer und damit insbesondere das Verhältnis zwischen Weg und Kraft kleiner ist als bei einer geringeren Steigung.

Zur optimalen Anpassung können auch mehr als zwei unterschiedliche Neigungsbereiche oder ein kurvenförmiger Neigungsvorlauf vorgesehen sein, um den Anhebevorgang wunschgemäß zu steuern, wodurch eine besonders hohe Flexibilität erreicht wird.

In einer bevorzugten Weiterbildung aller zuvor beschriebenen Ausgestaltungen ist eine Federeinrichtung vorgesehen, die die Betätigungseinrichtung in eine vorbestimmte Position vorbelastet. Vorzugsweise ist die vorbestimmte Position die Verriegelungsposition, um sicherzustellen, dass sich kein Steckmodul unerwünscht löst.

In allen Ausgestaltungen ist der Einsatz einer einzigen Betätigungseinrichtung bevorzugt, wobei die Betätigungseinrichtung besonders bevorzugt auf mehrere Verriegelungselemente einwirkt. Dabei erfolgt die Einwirkung insbesondere gleichzeitig, kann aber auch auf die einzelnen Verriegelungselemente nacheinander erfolgen.

Besonders bevorzugt ist die Betätigungseinrichtung einteilig mit wenigstens einem Verriegelungselement und insbesondere mit zwei oder mehr Verriegelungselementen gebildet. Eine solche Betätigungseinrichtung ist vorteilhaft, da sie vorzugsweise von einer Seite des Gehäuses bedienbar ist, wobei dann durch die Betätigung der Betätigungseinrichtung alle vorhandenen Verriegelungselemente gelöst werden.

In allen Ausgestaltungen ist die Anhebeeinrichtung insbesondere derart gestaltet, dass beim Entriegeln ein aufgenommenes Einsteckmodul geradlinig angehoben wird, um ein Verkanten der Kontakte zu verhindern.

Vorteilhafterweise ist die Betätigungseinrichtung im Wesentlichen stabförmig ausgebildet und weist in der Nähe beider Enden jeweils wenigstens ein Verriegelungselement auf, sodass bei Einsatz eines stabförmigen und langgestreckten Betätigungselements an beiden Enden der Betätigungseinrichtung beim Entriegeln eine Aushebekraft auf das Einsteckmodul ausgeübt wird.

An dieser Stelle wird darauf hingewiesen, dass es im Sinne der Anmeldung möglich ist, dass ein Entriegeln und ein Anheben des Einsteckmoduls gleichzeitig erfolgt. Vorzugsweise wird bei der Betätigung der Betätigungseinrichtung zunächst eine Entriegelung bewirkt und im direkten Anschluss daran ein Anheben des Einsteckmoduls. Dazu sind die Kontaktflächen in der translatorischen Richtung versetzt zugeordnet.

Die einzelnen Verriegelungselemente können als Hintergriff oder dergleichen ausgebildet sein, um entsprechende Komponenten der Einsteckmodule zu hintergreifen.

Das erfindungsgemäße Gehäuse weist wenigstens eine Modulaufnahme zur Aufnahme wenigstens eines Einsteckmoduls auf und ist mit einer Verriegelungseinrichtung ausgerüstet, die eine Betätigungseinrichtung umfasst. Dabei ist das Einsteckmodul derart ausgebildet, dass sowohl ein Verriegeln als auch ein Entriegeln möglich ist. Die Betätigungseinrichtung ist mit einer Anhebeeinrichtung verbunden, um beim Entriegelvorgang ein aufgenommenes Einsteckmodul anzuheben.

Besonders bevorzugt weist das erfindungsgemäße Gehäuse eine Verriegelungseinrichtung auf, wie sie zuvor beschrieben wurde.

Vorzugsweise umfasst die Verriegelungseinrichtung an beiden Enden der Modulaufnahme jeweils zwei seitlich beabstandete Verriegelungselemente, sodass das Einsteckmodul an den beiden Enden in der Modulaufnahme an jeweils zwei Stellen gesichert wird.

In allen Ausgestaltungen ist in dem Gehäuse ein Schaltungsträger, insbesondere eine Platine, vorgesehen, die elektrische Steckverbinder aufweist, die an der Modulaufnahme angeordnet sind.

Zur verbesserten Betätigung der Betätigungseinrichtung weist diese vorzugsweise eine Tasche auf, um die Betätigungseinrichtung mit einem Betätigungselement z.B. einem Schraubendreher betätigen zu können. Zur Erleichterung der Bedienung ist vorzugsweise ein Gegenlager an dem Gehäuse oder dem Einsteckmodul vorgesehen, um eine Kraftübersetzung zu ermöglichen, sodass die Betätigungseinrichtung einfach und zuverlässig bedienbar ist. Das Übersetzungsverhältnis ergibt sich aus der Länge des Betätigungselementes.

Des Weiteren ist die Erfindung auch auf ein Modulsystem ausgerichtet, welches ein Gehäuse und wenigstens ein daran aufgenommenes Einsteckmodul aufweist, wobei weiterhin wenigstens eine Verriegelungseinrichtung vorgesehen ist, welche entweder an dem Gehäuse oder an dem Einsteckmodul angeordnet ist. Dabei ist die Verriegelungseinrichtung und/oder das Gehäuse gemäß einer der zuvor beschriebenen Ausgestaltungen ausgebildet.

Die Erfindung ermöglicht zur Verriegelung bzw. zur Entriegelung ein gradliniges Stecken und Ziehen, wobei die Betätigung auf einer Seite des Gehäuses sehr platzsparend erfolgen kann. So ist auch die Bedienung bei beengten Raumverhältnissen möglich.

Es werden wenig Einzelteile für die Verriegelungseinrichtung benötigt und die Montage der Verriegelungseinheit ist einfach an dem Gehäuse oder dem Steckmodul möglich. Gegenüber herkömmlichen Systemen, bei denen ein Verschrauben der Module erfolgt, wird ein erheblicher Zeitaufwand gespart, und es wird eine Anhebe- bzw. Ausdrückfunktion integriert, mit der die hohen Haltekräfte der hochpoligen Steckverbinder überwunden werden können. Durch die an der Betätigungseinrichtung vorgesehene Tasche oder Lasche oder dergleichen wird eine Umsetzung der Bewegung ermöglicht.

Vorzugsweise verschiebt das Einsteckmodul beim Einstecken in das Gehäuse mit entsprechenden Füßen oder Kanten die Verriegelungselemente quer zur Steckrichtungen gegen die Federkraft der eingesetzten Feder. Wenn das Modul auf die vorgesehene Tiefe in das Trägergehäuse eingesteckt ist, geben die Füße des Einsteckmoduls die Verriegelungselemente frei, sodass eine Verriegelung des Einsteckmoduls erfolgt. Zum Entriegeln wird die Verriegelungseinrichtung gegen die Federkraft axial bewegt, sodass die Verriegelungselemente freigegeben werden. Im weiteren Verlauf der Entriegelungsbewegung drücken die an der Betätigungseinrichtung bzw. an der Anhebevorrichtung vorgesehenen Schrägen gegen entsprechende Schrägen oder Kanten am Einsteckmodul, sodass das Einsteckmodul unter Überwindung der vorhandenen Kontaktkräfte herausgedrückt wird.

Weitere Vorteile und Merkmale der vorliegenden Erfindung ergeben sich aus der Beschreibung des Ausführungsbeispieles, das im Folgenden mit Bezug auf die beigefügten Zeichnungen erläutert wird.

Darin zeigen:
- Fig. 1: eine perspektivische Ansicht eines erfindungsgemäßen Gehäuses mit einem eingesetzten Einsteckmodul;
- Fig. 2: eine erfindungsgemäße Verriegelungseinrichtung in einer perspektivischen Ansicht;
- Fig. 3: eine teilweise geschnittene perspektivische Ansicht des Gehäuses mit eingesetztem Einsteckmodul;
- Fig. 4: eine vergrößerte Darstellung eines Details aus Fig. 3;
- Fig. 5: das Gehäuse mit der Betätigungseinrichtung in einer ersten Stellung;
- Fig. 6: das Gehäuse in einer zweiten Position beim Betätigen der Betätigungseinrichtung;
- Fig. 7: das Gehäuse und die Verriegelungseinrichtung in der Entriegelungsposition; und
- Fig. 8: das Einsteckmodul in Perspektive von unten.

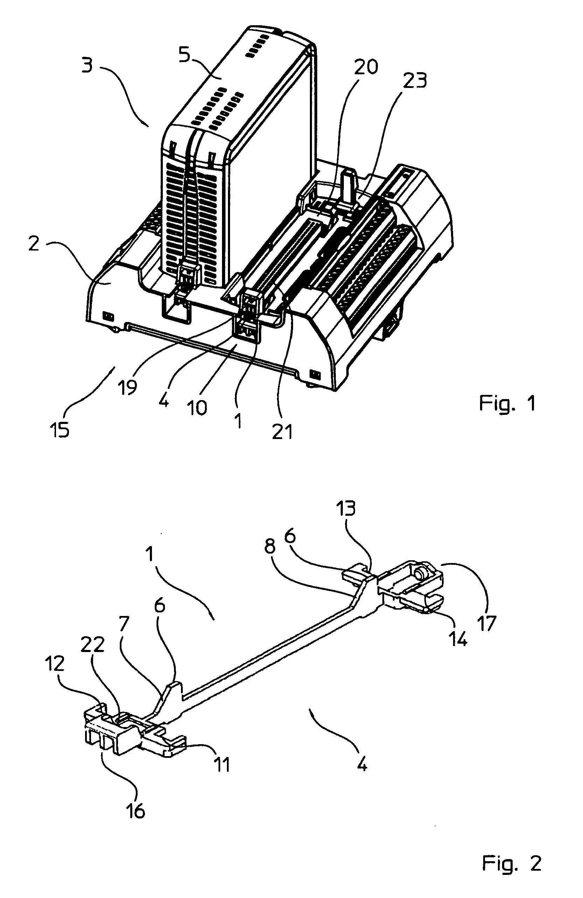

Das in Fig. 1 perspektivisch dargestellte Modulsystem 3 umfasst ein Gehäuse 2, ein aufgestecktes Steckmodul 5 und eine Verriegelungseinrichtung 1, von der nur das eine Ende 16 der Betätigungseinrichtung 4 sichtbar ist.

Das Einsteckmodul bzw. Steckmodul 5 enthält üblicherweise mindestens einen Schaltungsträger, insbesondere eine Leiterplatte, mit hochpoligen Steckverbindern zur Kontaktierung auf entsprechende Gegenstecker in dem vorzugsweise als Trägergehäuse ausgeführten Gehäuse 2. Das Einsteckmodul 5 wird in das Gehäuse 2 eingesteckt und dort fixiert. Die Einsteckbewegung sowie auch die Entnahmebewegung sind linear.

Hier im Ausführungsbeispiel weist das Steckmodul 5 Füße 24 auf, die Hintergriffe zur Fixierung an der Verriegelungseinrichtung bereitstellen. Dabei können die Füße 24 Schrägen aufweisen, um die Verriegelungseinrichtung 1 beim Einstecken quer zur Steckrichtung zu verschieben, um das Fügen zu ermöglichen.

In dem Gehäuse 2 ist hier im Ausführungsbeispiel mindestens eine Leiterplatte vorgesehen, die die Gegenstecker für die Steckmodule 5 aufweist. Pro Steckmodul 5 ist eine Verriegelungseinrichtung 1 vorgesehen.

Bei dem Ausführungsbeispiel dient das Gehäuse 2 zur Aufnahme von zwei Einsteckmodulen 5, die benachbart parallel zueinander angeordnet werden können. Das Gehäuse 2 selbst wird wiederum an einer Tragschiene angebracht, an der eine Vielzahl solcher Modulsysteme 3 angeordnet werden. Durch die Vielzahl der angeordneten Modelsysteme 3 auf einer solchen Hut- oder Tragschiene (nicht dargestellt) sind die Platzverhältnisse zum Einstecken oder Abziehen der einzelnen Einsteckmodule 5 beengt. Hier bietet die Erfindung erhebliche Vorteile, da nur durch Betätigung der Betätigungseinrichtung 4 ein Einsteckmodul 5 entriegelt und angehoben wird, sodass eine Entnahme des Einsteckmoduls 5 aus der Modulaufnahme 20 einfach ist.

Beim Anhebevorgang dient die Außenführung 23 auch dazu, die Anhebebewegung gradlinig verlaufen zu lassen.

An der Modulaufnahme 20 ist ein oder es sind mehrere Steckverbinder 21 vorgesehen, die mit entsprechenden Steckverbindern des Einsteckmoduls 5 verbunden werden.

Hier im Ausführungsbeispiel erfolgt die Bedienung der Betätigungseinrichtung 4 von der vorderen Seite 15. Grundsätzlich kann die Betätigung auch von der anderen Seite aus erfolgen.

Die in Fig. 2 perspektivisch dargestellte Verriegelungseinrichtung 1 ist hier im Wesentlichen als langgestreckter Stab ausgeführt, an dem in der Nähe der beiden Enden 16,17 die Verriegelungselemente 11,12 und 13,14 angeordnet sind. Hier sind in unmittelbarer Nachbarschaft der Verriegelungselemente Anhebeflächen 7 und 8 der Anhebeeinrichtung 6 vorgesehen. Die Anordnung von zwei oder mehr schrägen Anhebeflächen 7,8 stellt ein gradliniges Einführen und Ausführen des Einsteckmoduls 5 sicher.

Hier im Ausführungsbeispiel ist der Mittelbereich der Betätigungseinrichtung 4 relativ biegeweich und an den Enden der Betätigungseinrichtung 4 befinden sich die Verriegelungselemente 11 und 12 bzw. 13 und 14.

Die Anordnung und die Anzahl der Verriegelungselemente 11 - 14 resultiert aus dem vorhandenen Bauraum und den technischen Anforderungen. So sind in anderen Ausgestaltungen auch nur zwei Verriegelungselemente möglich oder es können auch mehr als vier Verriegelungselemente vorgesehen sein. Zur Entriegelung wird die Betätigungseinrichtung von einer Seite aus aktiviert. Grundsätzlich ist es aber möglich, die Betätigungseinrichtung wahlweise von der einen oder von der anderen Seite aus zu betätigen, um eine noch flexiblere Ausgestaltung zu ermöglichen. So erfolgt eine einseitige Betätigung, wobei die Seite des Gehäuses gewählt werden kann.

Bei der Verriegelung greifen die Verriegelungselemente 11,12 und 13,14 hinter entsprechend angepasst ausgebildeten Hintergriffe an den Füßen des Einsteckmoduls 5 und sichern durch einen Formschluss die Verriegelungsposition 10.

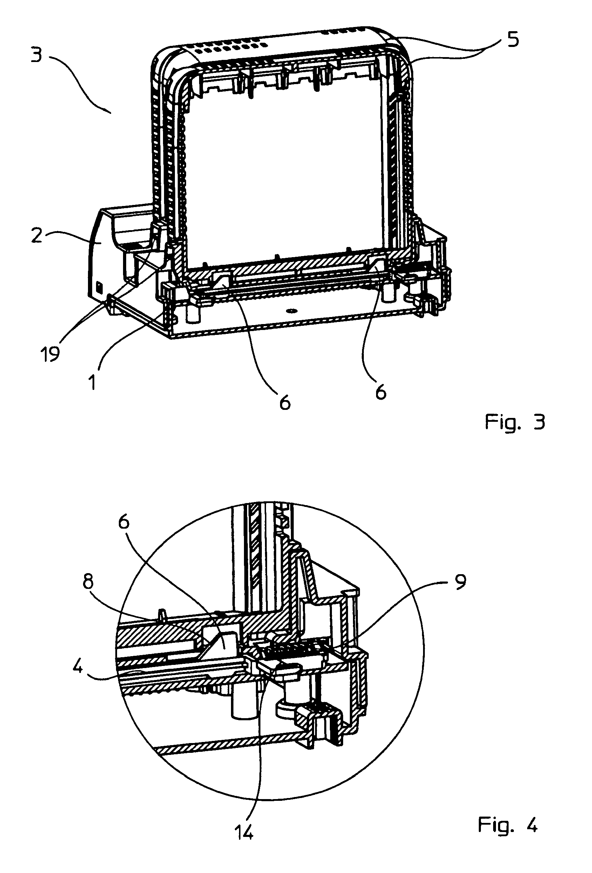

Fig. 3 zeigt eine teilweise geschnittene perspektivische Ansicht des Modulsystems, wobei die Verriegelungseinrichtung 1 an dem Gehäuse erkennbar ist. Deutlich sichtbar sind die zwei Anhebeflächen 7,8 der Anhebeeinrichtung 6, die jeweils in der Nähe der Enden 16,17 der Verriegelungseinrichtung 1 angeordnet sind, um ein gleichmäßiges und gradliniges Anheben oder Auswerfen des Einsteckmoduls zu gewährleisten.

Fig. 4 zeigt einen vergrößerten Ausschnitt aus Fig. 3, wobei die Feder 9 der Verriegelungseinrichtung 1 klar erkennbar ist.

Die Feder 9 dient dazu, die Verriegelungseinrichtung in der "O-Stellung" bzw. in der Verriegelungsstellung im Gehäuse zu halten. Weiterhin wird durch die Feder eine spielfreie Aufnahme des Steckmoduls 5 in dem Gehäuse 2 ermöglicht. Ohne eine solche Feder könnten sich beim Auftreten von z.B. Vibrationen Kräfte auf das Einsteckmodul 5 ergeben, die das Einsteckmodul in die Ziehrichtung bewegen, da durch im Eingriff befindliche Schrägen das Modul teilweise freigegeben werden könnte. Durch die Feder wird eine Vorbelastung ausgeübt, die solche Bewegungen zuverlässig verhindert.

Weiterhin ist es ein Vorteil der Feder, dass die Feder unabhängig von der Einbausituation des Gehäuses und der Verriegelungseinrichtung auch gegen die Schwerkraft die Verriegelungselemente in der Verriegelungsstellung hält.

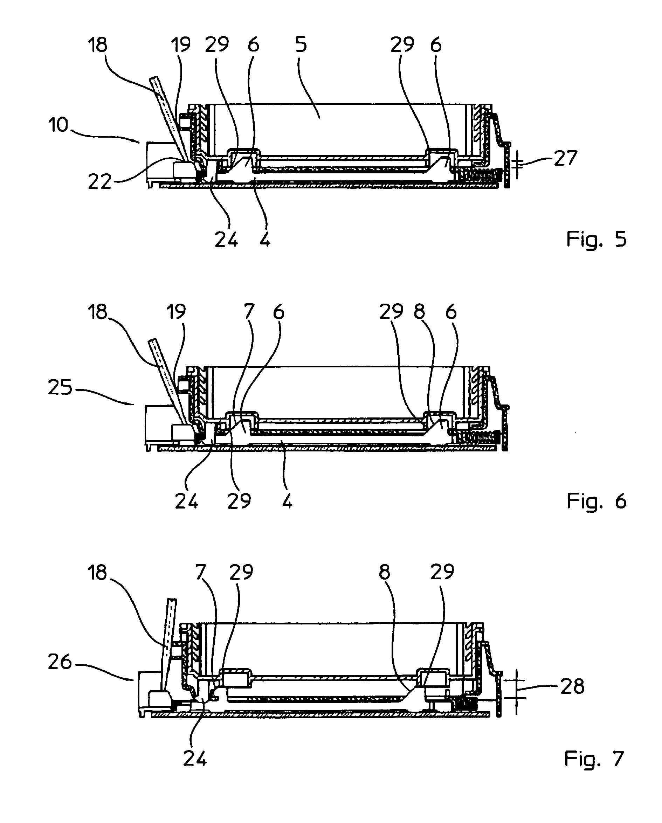

Mit Bezug auf die Fig. 5 - 8 wird nun die Funktion der Verriegelungseinrichtung beschrieben. In das in Fig. 5 in einer geschnittenen Seitenansicht gezeigte Gehäuse 2 ist Einsteckmodul 5 eingesetzt, das Aufnahmeeinrichtungen 29 aufweist, die im verriegelten Zustand nicht in Kontakt mit den Anhebeflächen 7,8 der Anhebeeinrichtung 6 stehen. In dem in Fig. 5 dargestellten verriegelten Zustand liegt ein Abstand 27 des Gehäusebodens zum Einsteckmodul vor. Durch Einsetzen eines Schraubendrehers 18 in die Tasche 22 der Betätigungseinrichtung 4 und durch Anlegen des Schraubendrehers an das Gegenlager 19 wird der Entriegelungsvorgang begonnen.

Bei der in Fig. 6 gezeigten Stellung wurde der Schraubendreher 18 um das Gegenlager 19 herum geschwenkt, sodass in der Stellung gemäß Fig. 6 die Verriegelungseinrichtung 4 mit dem Anhebeflächen 7,8 die Aufnahmeeinrichtungen 29 des Einsteckmoduls kontaktiert, während die Verriegelungselemente 11 - 14 schon freigegeben sind, sodass eine Auswurfbewegung des Einsteckmoduls 5 folgen kann. Bei einer nun weiter erfolgenden axialen Bewegung gleiten die Aufnahmeeinrichtungen 29 entlang der geneigten Anhebeflächen 7,8, sodass das Einsteckmodul 5 aus dem Gehäuse herausgedrückt wird.

In Fig. 7 ist der Zustand dargestellt, wenn der noch in der Tasche 22 eingreifende Schraubendreher 18 soweit geschwenkt wurde, dass das Einsteckmodul 5 von dem Gehäuse 2 abgehoben hat, sodass nun ein Abstand 28 vorliegt, der deutlich größer als der in Fig. 5 dargestellte Abstand 27 ist.

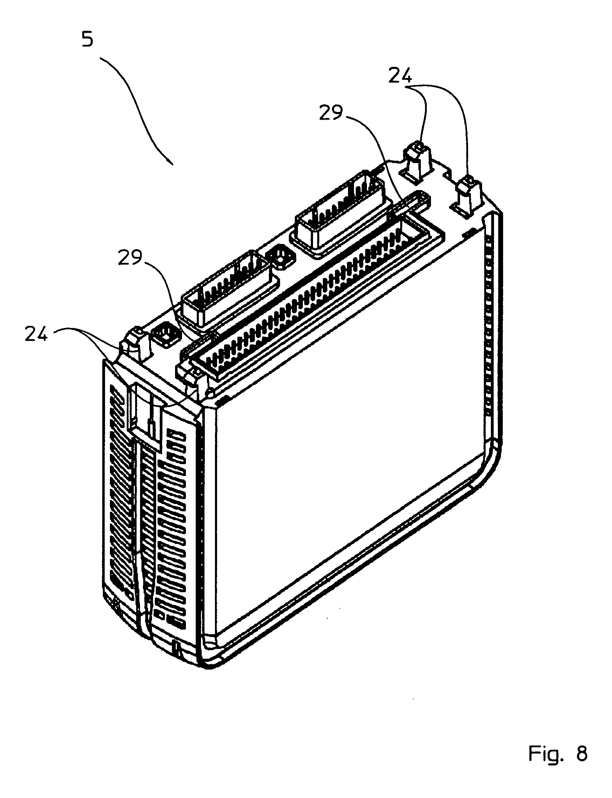

Fig. 8 zeigt das Einsteckmodul in perspektivischer Ansicht von unten, wobei die Füße 24 als auch die Aufnahmeeinrichtung 29 gut erkennbar sind.

### Bezugszeichenliste

- 1: Verriegelungseinrichtung
- 2: Gehäuse
- 3: Modulsystem
- 4: Betätigungseinrichtung
- 5: Einsteckmodul
- 6: Anhebeeinrichtung
- 7: Anhebefläche
- 8: Anhebefläche
- 9: Feder
- 10: Verriegelungsposition
- 11: Verriegelungselement
- 12: Verriegelungselement
- 13: Verriegelungselement
- 14: Verriegelungselement
- 15: Seite
- 16: Ende
- 17: Ende
- 18: Betätigungselement
- 19: Gegenlager
- 20: Modulaufnahme
- 21: Steckverbinder
- 22: Tasche
- 23: Außenführung
- 24: Fuß
- 25: 2. Position
- 26: Entriegelungsposition
- 27: Abstand
- 28: Abstand
- 29: Aufnahmeeinrichtung

## Patentansprüche

1. Verriegelungseinrichtung (1) für ein Gehäuse (2) zur Aufnahme wenigstens eines Einsteckmoduls (5), insbesondere mit Füßen (24), mit einer Betätigungseinrichtung (4) zum Entriegeln, insbesondere der Füße (24), des Einsteckmoduls (5),
**gekennzeichnet durch**
eine mit der Betätigungseinrichtung (4) verbundene Anhebeeinrichtung (6), die wenigstens eine geneigte Anhebefläche (7,8) aufweist, um mit dem Entriegeln ein in dem Gehäuse (2) aufgenommenes Einsteckmodul (5) anzuheben, wobei die Betätigungseinrichtung (4) zum Entriegeln translatorisch bewegbar ist, sowie dass die Betätigungseinrichtung (4) einteilig mit dem wenigstens einen Verriegelungselement (11-14) gebildet ist.

2. Verriegelungseinrichtung (1) nach Anspruch 1, wobei wenigstens eine Anhebefläche (7,8) wenigstens zwei Bereiche mit unterschiedlichen Neigungen aufweist oder kurvenförmig gestaltet ist, um den Anhebevorgang entsprechend zu steuern.

3. Verriegelungseinrichtung (1) nach Anspruch 1 oder 2, wobei die Betätigungseinrichtung (4) mit einer Federeinrichtung (9) in eine Verriegelungsposition (10) vorbelastet wird.

4. Verriegelungseinrichtung (1) nach einem der vorhergehenden Ansprüche, wobei die Betätigungseinrichtung (4) im Wesentlichen stabförmig ausgebildet ist und in der Nähe beider Enden (16,17) jeweils wenigstens ein Verriegelungselement (11,12;13,14)aufweist.

5. Gehäuse (2) mit wenigstens einer Modulaufnahme (20) zur Aufnahme wenigstens eines Einsteckmoduls (5) und mit einer mit einer Betätigungseinrichtung (4) ausgerüsteten Verriegelungseinrichtung (1) nach Anspruch 1, welche geeignet ist, ein aufgenommenes Einsteckmodul (5) zu verriegeln und zu entriegeln.

6. Gehäuse (2) nach Anspruch 5, wobei die Verriegelungseinrichtung (1) an beiden Enden (16,17) der Modulaufnahme (20) jeweils zwei seitlich beabstandete Verriegelungselemente (11,12;13,14)aufweist.

7. Gehäuse (2) nach einem der vorhergehenden Ansprüche 5 bis 6, wobei ein Schaltungsträger, insbesondere eine Platine vorgesehen ist, die elektrische Steckverbinder (21) aufweist, die an der Modulaufnahme (20) angeordnet sind.

8. Gehäuse (2) nach einem der vorhergehenden Ansprüche 5 bis 7, wobei die Betätigungseinrichtung (4) eine Tasche (22) aufweist, um die Betätigungseinrichtung (4) mit einem Betätigungselement (18) betätigen zu können.

9. Gehäuse (2) nach einem der vorhergehenden Ansprüche 5 bis 8, wobei ein Gegenlager (19) zur Anlage des Betätigungselements (18) vorgesehen ist.

10. Modulsystem (3) mit einem Gehäuse (2) und wenigstens einem daran aufgenommenen Einsteckmodul (5) und mit wenigstens einer Verriegelungseinrichtung (1) nach einem der Ansprüche 1 bis 4, wobei die Verriegelungseinrichtung (1) an dem Gehäuse (2) oder an dem Einsteckmodul (5) angeordnet ist.

## Claims

1. Locking device (1) for a housing (2) for holding at least one plug-in module (5), in particular with feet (24), with an operating device (4) for unlocking, in particular of the feet (24), of the plug-in module (5),
**characterized by**
a lifting device (6), which is connected to the operating device (4) and has at least one inclined lifting surface (7, 8), in order to lift a plug-in module (5), which is held in the housing (2), with the unlocking process, wherein the operating device (4) can be moved translationally for unlocking, and wherein the operating device (4) is formed integrally with the at least one locking element (11-14).

2. Locking device (1) according to Claim 1, wherein at least one lifting surface (7, 8) has at least two areas with different inclinations, or is curved, in order to appropriately control the lifting process.

3. Locking device (1) according to claim 1 or 2, wherein the operating device (4) is preloaded to a locking position (10) by a spring device (9).

4. Locking device (1) according to one of the preceding claims, wherein the operating device (4) is essentially in the form of a rod and has at least one locking element (11, 12; 13, 14) in the vicinity of each of the two ends (16, 17).

5. Housing (2) having at least one module holder (20) for holding at least one plug-in module (5), and having a locking device (1), which is equipped with an operating device (4), according to Claim 1, which locking device (1) is suitable for locking and unlocking a plug-in module (5) which is held.

6. Housing (2) according to Claim 5, wherein the locking device (1) has two locking elements (11, 12; 13, 14), which are separated laterally, at each of the two ends (16, 17) of the module holder (20).

7. Housing (2) according to one of the preceding claims 5 or 6, wherein a circuit mount, in particular a board, is provided, which has an electrical plug connector (21) which is arranged on the module holder (20).

8. Housing (2) according to one of the preceding claims 5 to 7, wherein the operating device (4) has a pocket (22) in order to allow the operating device (4) to be operated by an operating element (18).

9. Housing (2) according to one of the preceding claims 5 to 8, wherein an opposing bearing (19) is provided for the operating element (18) to make contact with.

10. Module system (3) having a housing (2) and at least one plug-in module (5) held thereon, and having at least one locking device (1) according to one of Claims 1 to 4, wherein the locking device (1) is arranged on the housing (2) or on the plug-in module (5).

## Revendications

1. Dispositif de verrouillage (1) pour un boîtier (2) pour loger au moins un module enfichable (5), notamment muni de pattes (24), avec un dispositif d'actionnement (4) pour le déverrouillage, notamment des pattes (24), du module enfichable (5),
**caractérisé par** un dispositif de soulèvement (6) relié au dispositif d'actionnement (4) et comportant au moins une surface de soulèvement inclinée (7, 8) pour, avec le déverrouillage, soulever un module enfichable (5) logé dans le boîtier (2), le dispositif d'actionnement (4) pouvant être déplacé en translation pour le déverrouillage,
et **caractérisé en ce que** le dispositif d'actionnement (4) est formé d'un seul tenant avec l'au moins un élément de verrouillage (11, 14).

2. Dispositif de verrouillage (1) selon la revendication 1, dans lequel au moins une surface de soulèvement (7, 8) comporte au moins deux zones ayant des inclinaisons différentes ou est conçue en forme de courbe pour commander de manière correspondante l'opération de soulèvement.

3. Dispositif de verrouillage (1) selon la revendication 1 ou 2, dans lequel le dispositif d'actionnement (4) est précontraint en une position de verrouillage (10) par un dispositif à ressort (9).

4. Dispositif de verrouillage (1) selon l'une des revendications précédentes, dans lequel le dispositif d'actionnement (4) est conçu essentiellement en forme de barre et comporte, près des deux extrémités (16, 17), respectivement au moins un élément de verrouillage (11, 12 ; 13, 14).

5. Boîtier (2) avec au moins un logement de module (20) pour loger au moins un module enfichable (5) et avec un dispositif de verrouillage (1) selon la revendication 1 équipé d'un dispositif d'actionnement (4), lequel est approprié pour verrouiller et déverrouiller un module enfichable (5) logé.

6. Boîtier (2) selon la revendication 5, dans lequel le dispositif de verrouillage (1) comporte aux deux extrémités (16, 17) du logement de module (20) respectivement deux éléments de verrouillage (11, 12; 13, 14)espaçés latéralement l'un de l'autre.

7. Boîtier (2) selon l'une des revendications précédentes 5 à 6, dans lequel un support de circuit, notamment une carte de circuits imprimés, est prévu, qui comporte des connecteurs électriques multibroches (21) qui sont agencés sur le logement de module (20).

8. Boîtier (2) selon l'une des revendications précédentes 5 à 7, dans lequel le dispositif d'actionnement (4) comporte une poche (22) pour pouvoir actionner le dispositif d'actionnement (4) avec un élément d'actionnement (18).

9. Boîtier (2) selon l'une des revendications précédentes 5 à 8, dans lequel une butée (19) pour l'appui de l'élément d'actionnement (18) est prévu.

10. Système de module (3) avec un boîtier (2) et au moins un module enfichable (5) logé sur celui-ci et avec au moins un dispositif de verrouillage (1) selon l'une des revendications 1 à 4, dans lequel le dispositif de verrouillage (1) est agencé sur le boîtier (2) ou sur le module enfichable (5).
